# EUROPEAN PATENT APPLICATION

(11) **EP 3 731 264 A1**
(43) Date of publication of application: **28.10.2020**
(21) Application number: 17904364.1
(22) Date of filing: 25.12.2017
(51) Int. Cl.: H01L 21/67, H01L 21/365, H01L 31/032, H01L 31/18

(54) **SYSTEM AND METHOD FOR CIGS THIN FILM PRETREATMENT**

(30) Priority: 20.12.2017 CN 201711385518
(71) Applicant: Beijing Apollo Ding Rong Solar Technology Co., Ltd., Beijing 100176 (CN)
(72) Inventor: XU, Yi, Beijing 100176 (CN)
(74) Representative: Cohausz & Florack
(86) International application number: PCT/CN2017/118221
(87) International publication number: WO 2019/119464

(57) **Abstract**

A system and a method for CIGS thin film pretreatment are provided by the invention. The system includes a RF power supply, an inductance coil, a process chamber, adaptation modules, a cathode plate and a quartz cover. The inductance coil is circumferentially disposed on a top of the process chamber. The cathode plate is disposed at a bottom of the process chamber. A substrate is disposed between the inductance coil and the cathode plate. The RF power supply includes a first power supply and a second power supply, wherein the first power supply powers the inductance coil via the adaptation module, and the second power supply powers the cathode plate via the adaptation module. Rays formed by the inductance coil enter the process chamber through the quartz cover under an action of the RF voltage, so that a process gas in the process chamber forms plasma. The plasma moves towards the cathode plate and bombards an uneven region of a CIGS thin film on the substrate under the action of the voltage, so as to flatten the CIGS thin film.

## Description

### TECHNICAL FIELD

The present invention relates to the technology field of solar cell thin film, and more particularly, relates to a system and a method for thin film pretreatment.

### BACKGROUND

In existing solar cell technologies, copper indium gallium selenide ("CIGS" for short) thin film solar cells have the advantages of strong light absorption capability, good stability, good radiation resistance, high efficiency and low cost, and they can be made into flexible components, which are most suitable for manufacturing photovoltaic cells. In the manufacture process for a CIGS thin film, it mainly uses plasma deposition. Plasma is a set composed of free charged particles doing random motion. The simplest formation method of plasma is to drive two plates via a radio frequency ("RF" for short) voltage source, making low-pressure gas between the two plates generate a discharge phenomenon. When a current flows from one plate to the other, the gas is "punctured" to generate the plasma. Plasma discharge can produce substance with chemical activity which is deposited on a surface layer of a substrate to form the thin film. However, an excessively high plasma density easily causes excessive damage to a surface of a substrate, resulting in excessive defects in a manufactured thin film, which seriously affects the efficiency of a device. Moreover, the higher a RF frequency is, the less uniform a plasma distribution is, which may result in poor film formation uniformity on the surface of the substrate. Therefore, the surface smoothing treatment for the CIGS thin film has great application prospects and economic values.

### SUMMARY

The present invention provides a system and a method for CIGS thin film pretreatment. A problem of the existing CIGS thin film, manufactured via a process using plasma, having an uneven and out-of-flatness surface is solved. A flatter surface of the thin film can be obtained, and the absorption rate and stability of the CIGS thin film solar cells is improved.

In order to achieve above objectives, the present invention provides the following technical solutions:
A system for CIGS thin film pretreatment includes: a RF power supply, an inductance coil, a process chamber, adaptation modules, a cathode plate and a quartz cover.

The inductance coil is circumferentially disposed on a top of the process chamber. The cathode plate is disposed at a bottom of the process chamber. A substrate is disposed between the inductance coil and the cathode plate.

The RF power supply provides power supply for the inductance coil at first power via an adaptation module, and provides power supply for the cathode plate at second power via an adaptation module, wherein the first power is greater than the second power.

The adaptation modules are configured to adjust currents of the inductance coil and the cathode plate to form a RF voltage, and make the inductance coil generate rays with a specified frequency;
the rays formed by the inductance coil enter the process chamber through the quartz cover under an action of the RF voltage, so that a process gas in the process chamber forms plasma, and the plasma moves towards the cathode plate and bombards an uneven region of a CIGS thin film on the substrate under the action of the voltage, so as to flatten the CIGS thin film.

Preferably, the inductance coil is a Cu coil, and the inductance coil is spirally disposed on the top of the process chamber.

Preferably, the process gas is argon.

Preferably, the adaptation module includes a first capacitor and a second capacitor. The first capacitor is a tunable capacitor, and the second capacitor is a fixed capacitor. The first capacitor is connected with the inductance coil in series, and the second capacitor is connected with the inductance coil in parallel.

Preferably, the substrate is a glass substrate.

Preferably, a heating device is included.

The heating device is disposed in the process chamber to maintain a temperature of the process gas within a preset temperature range.

The present invention further provides a method for CIGS thin film pretreatment. The method includes:
(1) disposing circumferentially an inductance coil on a top of a process chamber, disposing a cathode plate at a bottom of the process chamber, and disposing a substrate between the inductance coil and the cathode plate;
(2) providing power supply for the inductance coil at first power, and providing power supply for the cathode plate at second power, to form a RF voltage between the voltage coil and the cathode plate, wherein the first power is greater than the second power; and
(3) making rays formed by the inductance coil enter the process chamber through a quartz cover under an action of the RF voltage, making a process gas in the process chamber which is vacuum form a plasma, starting to move the plasma towards the cathode plate and bombarding an uneven region of a CIGS thin film on the substrate under the action of the voltage, so as to flatten the CIGS thin film.

Preferably, before step (2), the method further includes following steps:
preparing the copper indium gallium selenide CIGS thin film on the substrate, and placing the CIGS thin film which has been prepared in the process chamber; and
injecting the process gas into the process chamber.

Preferably, before the step (3), the method further includes a following step:
turning on the RF power supply, and adjusting a current, for the purpose of making the inductance coil generate rays with a specified frequency and making the process gas form the plasma.

Preferably, the method further includes:
maintaining a temperature of the process gas within a preset temperature range.

The invention provides a system and a method for CIGS film pretreatment. The system powers the inductance coil and the cathode plate via the RF power supply to form the RF voltage, so that the rays generated by the inductance coil make the process gas form the plasma in the process chamber, and the plasma bombards the uneven region of the CIGS thin film. The problem of the existing CIGS thin film, manufactured via a process using plasma, having an uneven and out-of-flatness surface is solved. A flatter surface of the thin film can be obtained, and the absorption rate and the stability of the CIGS thin film solar cells is improved.

### BRIEF DESCRIPTION OF THE DRAWINGS

In order to describe detailed embodiments of the present invention more clearly, the accompanying drawings to be used for describing the embodiments will be introduced briefly.
Fig. 1 is a schematic diagram of a system for CIGS thin film pretreatment provided by the present invention.
Fig. 2 is a flow chart of a method for CIGS thin film pretreatment provided by the present invention.

### Reference Signs:

1. inductance coil
2. quartz cover
3. process chamber
4. substrate
5. cathode plate
6. adaptation module
7. heating device
8. first power supply
9. second power supply

### DETAILED DESCRIPTION

In order to enable those skilled in the art to understand the solutions of embodiments of the present invention better, the embodiments of the present invention will be further described in detail below with reference to the accompanying drawings and the implementations.

In view of the problem of the CIGS thin film, manufactured via a process using plasma, of the current solar cell having an uneven and out-of-flatness surface, the present invention provides a system and a method for CIGS thin film pretreatment. An inductance coil and a cathode plate are powered by a RF power supply to form a RF voltage, so that rays generated by the inductance coil make a process gas form plasma in a process chamber, and the plasma bombards an uneven region of the CIGS thin film. Thereby, a flatter surface of the thin film is obtained, and the absorption rate and stability of the CIGS thin film solar cell are improved.

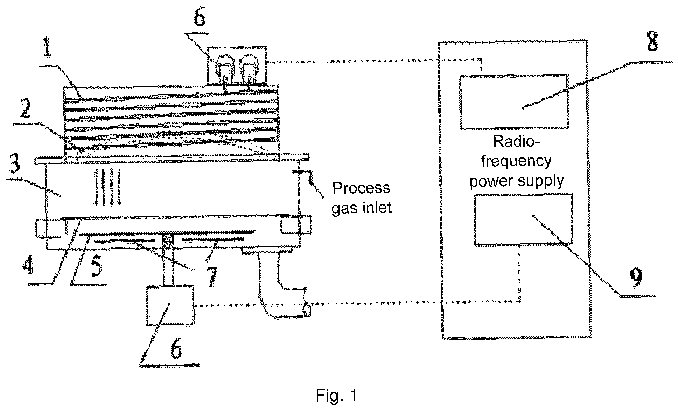

As shown in Fig. 1, a system for CIGS thin film pretreatment includes a RF power supply, an inductance coil 1, a process chamber 3, adaptation modules 6, a cathode plate 5, and a quartz cover. The inductance coil 1 is circumferentially disposed on a top of the process chamber 3. The cathode plate 5 is disposed at a bottom of the process chamber 3. A substrate 4 is disposed between the inductance coil 1 and the cathode plate 5. The RF power supply includes a first power supply 8 and a second power supply 9. The first power supply 8 powers the inductance coil 1 via an adaptation module 6, and the second power supply 9 powers the cathode plate 5 via an adaptation module 6, wherein the first power is greater than the second power. The adaptation modules 6 are configured to adjust currents of the inductance coil 1 and the cathode plate 5 to form a RF voltage, and make the inductance coil 1 generate rays with a specified frequency. Under an action of the RF voltage, rays formed by the inductance coil 1 pass through the quartz cover 2 and enter the process chamber 3, making a process gas in the process chamber 3 form plasma. The plasma moves towards the cathode plate 5 and bombards an uneven region of the CIGS thin film on the substrate 4 under the action of the voltage, so as to flatten the CIGS thin film.

Specifically, because there is a defect of unevenness on the surface of the CIGS thin film, bombardment intensity decays rapidly as a distance increases during the bombardment of the plasma. Under the bombardment of the plasma, a bulging part is closer to the plasma source and is subject to more bombardment. With more bombardment, the bugling part becomes smaller. A recessed part is farther away from the plasma source, and is subject to less bombardment. The difference between the two parts becomes smaller, which makes a plating more and more flatter.

The inductance coil is a Cu coil. The inductance coil is disposed in a spiral shape on the top of the process chamber. In the practical application, the copper coil is made of a high quality oxygen-free copper material, and is formed into a spiral circular shape by a copper wire having a diameter of 8 mm, which is raised by about 5 cm per turn and has a total height of about 40 cm. The greater a pitch between two turns of the Cu coil is, the smaller the density of produced plasma is, while the greater a capacitance is; conversely, the greater the density of the produced plasma is, while the smaller the capacitance is. It needs to find a suitable balance point between the plasma density and the capacitance, and the specific structure of the Cu coil is able to be verified by experiments.

The process gas is argon. Of course, another inert gas is also able be used. The substrate is a glass substrate, or is able to be a flexible substrate. The flexible substrate is made of titanium metal, stainless steel, or polyimide.

Further, the adaptation module includes a first capacitor and a second capacitor. The first capacitor is a tunable capacitor, and the second capacitor is a fixed capacitor. The first capacitor is connected with the inductance coil in series. The second capacitor is connected with the inductance coil in parallel.

It should be noted that, an adaptation modules needs to provide a starting effect on the RF voltage. The starting effect can be achieved by the discharge of the first capacitor and the second capacitor. In practical application, capacitors with high quality and large capacity are able to be used. Capacitance capacities of the capacitors are able to be 5000 pf and 3000 pf, respectively. The two capacitors are able to be fixed to parallel rails and are driven by two motors to move parallelly. During a commissioning process, a suitable power release point is obtained by adjusting positions of the capacitors.

Furthermore, the system further includes a heating device. The heating device is disposed in the process chamber to maintain the temperature of the process gas within a preset temperature range.

Specially, a RF power supply of 13.56 MH and of 10 kW or more is used. It discharges to the Cu coil via the first capacitor and the second capacitor. Strong rays formed by an annular Cu coil enter the chamber through a transparent quartz cover, starting the process gas Ar which is to bombard towards the glass substrate, achieving the purpose of uniformly etching the surface of a thin film layer on the substrate. The surface of the thin film layer which has been etched has good uniformity. It can improve the uniformity of the CIGS layer which is adhered and the optical absorption efficiency in the future.

It can be seen that the present invention provides a system for CIGS thin film pretreatment. The system powers the inductance coil and the cathode plate through the RF power supply to form the RF voltage, so that the rays generated by the inductance coil makes the process gas form the plasma in the process chamber, and the plasma bombards the uneven region of the CIGS thin film. The problem of the existing CIGS thin film, manufactured via a process using plasma, having an uneven and out-of-flatness surface is solved. A flatter surface can be obtained, and the absorption rate and stability of the CIGS thin film solar cells are improved.

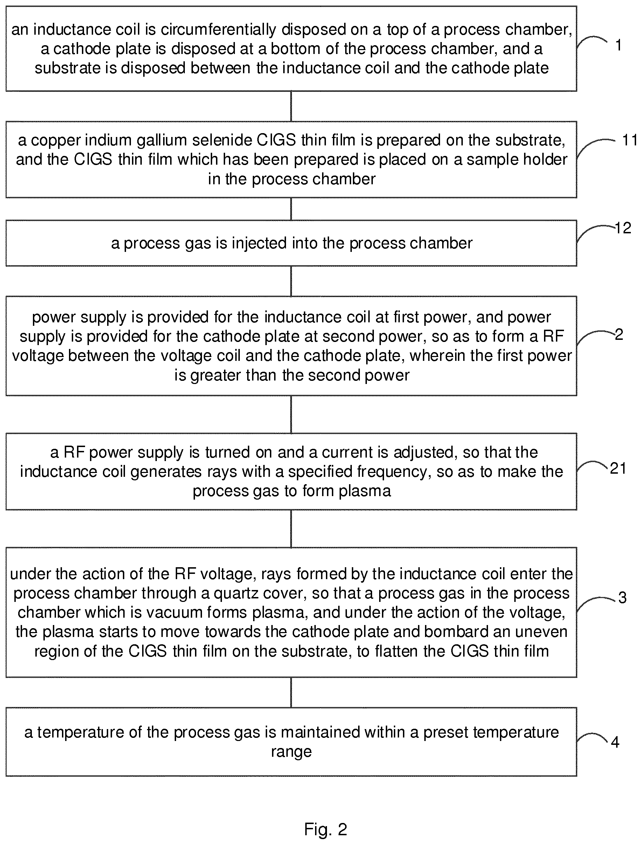

As shown in Fig. 2, the present invention further provides a method for CIGS thin film pretreatment. The method includes the following steps:
(1) An inductance coil is circumferentially disposed on a top of a process chamber. A cathode plate is disposed at a bottom of the process chamber. A substrate is disposed between the inductance coil and the cathode plate.
(2) Power supply is provided for the inductance coil at first power, and power supply is provided for the cathode plate at second power, so as to form a RF voltage between the voltage coil and the cathode plate, wherein the first power is greater than the second power.
(3) Under an action of the RF voltage, rays formed by the inductance coil enter the process chamber through a quartz cover, so that a process gas in the process chamber which is vacuum forms plasma. Under the action of the voltage, the plasma starts to move towards the cathode plate and bombards an uneven region of a CIGS thin film on the substrate, so as to flatten the CIGS thin film.

Before step (2), the method further include the following steps:
(11) The copper indium gallium selenide CIGS thin film is prepared on the substrate, and the CIGS thin film which has been prepared is placed on a sample holder in the process chamber;
(12) A process gas is injected into the process chamber.

Before step (3), the method further includes the following step:
(21) A RF power supply is turned on, and a current is adjusted, so that the inductance coil generates rays with a specified frequency, so as to make the process gas form the plasma.
(4) The method further includes: the temperature of the process gas is maintained within a preset temperature range.

It can be seen that the present invention provides a method for CIGS thin film pretreatment. The inductance coil and the cathode plate are powered by the RF power system, forming the RF voltage. Such that, the rays generated by the inductance coil make the process gas form the plasma in the process chamber, and the plasma bombards an uneven region of the CIGS thin film. The problem of the existing CIGS thin film, manufactured via a process using plasma, having an uneven and out-of-flatness surface is solved. A flatter surface of the thin film can be obtained, and the absorption rate and stability of the CIGS thin film solar cells are improved.

Configurations, features, and effects of the present invention are described in detail above with reference to the embodiments shown in the drawings. The above description shows only some preferred embodiments of the present invention, but implementing scope of the present invention is not limited by the the drawings. Any changes made in accordance with the conceptions of the present invention, or equivalent embodiments modified to equivalent changes without departing from the spirit of the specification and the drawings, are intended to be included within the scope of the present invention.

## Claims

1. A system for CIGS thin film pretreatment, **characterized by** comprising a radio frequency (RF) power supply, an inductance coil, a process chamber, adaptation modules, a cathode plate and a quartz cover, wherein,
the inductance coil is circumferentially disposed on a top of the process chamber, the cathode plate is disposed at a bottom of the process chamber, and a substrate is disposed between the inductance coil and the cathode plate;
the RF power supply comprises a first power supply and a second power supply, the first power supply powers the inductance coil via the adaptation module, and the second power supply powers the cathode plate via the adaptation module, wherein the first power is greater than the second power;
the adaptation modules are configured to adjust currents of the inductance coil and the cathode plate to form a RF voltage, and make the inductance coil generate rays with a specified frequency;
the rays formed by the inductance coil enter the process chamber through the quartz cover under an action of the RF voltage, making a process gas in the process chamber form plasma, and the plasma moves towards the cathode plate and bombards an uneven region of a CIGS thin film on the substrate under the action of the voltage, flattening the CIGS thin film.

2. The system for CIGS thin film pretreatment according to claim 1, **characterized in that** the inductance coil is a Cu coil, and the inductance coil is spirally disposed on the top of the process chamber.

3. The system for CIGS thin film pretreatment according to claim 2, **characterized in that** the process gas is argon.

4. The system for CIGS thin film pretreatment according to claim 3, **characterized in that** the adaptation module comprises a first capacitor and a second capacitor, wherein, the first capacitor is a tunable capacitor, the second capacitor is a fixed capacitor, the first capacitor is connected with the inductance coil in series, and the second capacitor is connected with the inductance coil in parallel.

5. The system for CIGS thin film pretreatment according to claim 4, **characterized in that**, the substrate is a glass substrate.

6. The system for CIGS thin film pretreatment according to claim 5, **characterized by** further comprising a heating device, wherein
the heating device is disposed in the process chamber to maintain a temperature of the process gas within a preset temperature range.

7. A method for CIGS thin film pretreatment, **characterized by** comprising:
(1) disposing circumferentially an inductance coil on a top of a process chamber, disposing a cathode plate at a bottom of the process chamber, and disposing a substrate between the inductance coil and the cathode plate;
(2) providing power supply for the inductance coil at first power, and providing power supply for the cathode plate at second power, to form a RF voltage between the voltage coil and the cathode plate, wherein the first power is greater than the second power; and
(3) making rays formed by the inductance coil enter the process chamber through a quartz cover under an action of the RF voltage, making a process gas in the process chamber which is vacuum form a plasma, starting to move the plasma towards the cathode plate and bombarding an uneven region of a CIGS thin film on the substrate under the action of the voltage, so as to flatten the CIGS thin film.

8. The method for CIGS thin film pretreatment according to claim 7, **characterized in that**, before the step (2), the method further comprises following steps:
preparing the copper indium gallium selenide CIGS thin film on the substrate, and placing the CIGS thin film which has been prepared in the process chamber; and
injecting the process gas into the process chamber.

9. The method for CIGS thin film pretreatment according to claim 8, , **characterized in that**, before the step (3), the method further comprises a following step:
turning on the RF power supply, and adjusting a current, for the purpose of making the inductance coil generate the rays with a specified frequency to make the process gas form the plasma.

10. The method for CIGS thin film pretreatment according to claim 9, **characterized by** further comprising:
maintaining a temperature of the process gas within a preset temperature range.
